Europäisches Patentamt

European Patent Office

Office européen des brevets

(11) Numéro de publication: **0 338 641**
**A1**

## (12) DEMANDE DE BREVET EUROPEEN

(21) Numéro de dépôt: 89200978.8

(22) Date de dépôt: 17.04.89

(51) Int. Cl.⁴: **H05K 3/30**

(30) Priorité: 22.04.88 FR 8805376

(43) Date de publication de la demande:
25.10.89 Bulletin 89/43

(84) Etats contractants désignés:
**DE FR GB IT NL**

(71) Demandeur: **RTC-COMPELEC**
**117, quai du Président Roosevelt**
**F-92130 Issy les Moulineaux(FR)**

(84) **FR**

Demandeur: **N.V. Philips'**
**Gloeilampenfabrieken**
**Groenewoudseweg 1**
**NL-5621 BA Eindhoven(NL)**

(84) **DE GB IT NL**

(72) Inventeur: **Thillays, Jacques**
**Société Civile S.P.I.D. 209, rue de**
**L'Université**
**F-75007 Paris(FR)**
Inventeur: **Blondet, Michel**
**Société Civile S.P.I.D. 209, rue de**
**L'Université**
**F-75007 Paris(FR)**
Inventeur: **Guilleman, Lionel**
**Société Civile S.P.I.D. 209, rue de**
**L'Université**
**F-75007 Paris(FR)**

(74) Mandataire: **Jacquard, Philippe et al**
**SOCIETE CIVILE S.P.I.D. 209, rue de**
**l'Université**
**F-75007 Paris(FR)**

(54) **Procédé de montage d'éléments optiques sur un support et circuit optique ainsi obtenu.**

(57) L'invention concerne le montage de d'éléments optiques sur un support. On réalise des fentes (24) en des endroits déterminés d'un support (20) isolant non rigide revêtu d'une piste conductrice (22) recouverte d'un matériau de soudure (30), on insère ensuite dans les fentes (24) un élément optique (25) présentant deux plages conductrices espacées (25′, 25″), de telle sorte que des éléments (25) soient retenus dans les fentes (24) et que leurs plages conductrices (25′, 25″) soient en contact avec le matériau de soudure (30) et on chauffe de manière à provoquer la fusion du matériau de soudure (30) pour souder les plages conductrices (25′, 25″) à la piste conductrice (22) correspondante.

FIG. 3b

## Procédé de montage d'éléments optiques sur un support, et circuit optique ainsi obtenu.

La présente invention se rapporte à un montage d'éléments sur un support pour réaliser un circuit optique.

Les dispositifs de signalisation actuellement connus tels que les feux rouges de circulation, ou bien les feux de position et d'indication de direction des véhicules mettent en oeuvre en général des lampes classiques à filament.

Il a déjà été proposé de les remplacer par des matrices d'éléments électro-luminescents, mais jusqu'à présent on s'est heurté à des difficultés quant au prix de revient en raison des opérations d'assemblage à mettre en oeuvre.

D'autre part, la demande s'oriente de plus en plus vers des dispositifs dont la faible épaisseur permette de les intégrer, dans une carrosserie par exemple pour les feux automobiles.

En outre, de nombreuses applications (informatique, sécurité etc...) requièrent des circuits comprenant de nombreux éléments optiques.

D'une manière générale, les techniques connues sont coûteuses.

L'invention propose ainsi de résoudre les problèmes de prix de revient tout en permettant l'obtention d'un circuit optique de faible épaisseur.

Le procédé de montage selon l'invention est ainsi caractérisé par les étapes suivantes :

a) réaliser des fentes de largeur sensiblement égale à une dimension d'un dit élément optique à des endroits déterminés d'un support isolant non rigide revêtu d'au moins une piste conductrice recouverte au moins partiellement d'un matériau de soudure de telle sorte que deux bords opposés desdites fentes jouxtent chacun une partie dudit matériau

b) introduire dans au moins certaines de ces fentes un élément optique présentant deux plages conductrices espacées selon ladite dimension de telle sorte que lesdits éléments optiques se trouvent retenus dans les fentes correspondantes et que leurs plages conductrices soient en contact avec lesdites parties dudit matériau

c) chauffer, par exemple par passage en continu dans un tunnel chauffant, de manière à provoquer la fusion dudit matériau de manière à réaliser une soudure entre chacune desdites plages conductrices et la piste conductrice correspondante.

Les éléments optiques peuvent être des diodes électroluminescentes, des photo-récepteurs, ou des pièces optiques de petites dimensions (prismes etc...) dont deux faces opposées sont métallisées.

La piste conductrice peut être en cuivre, et ledit matériau de soudure à base d'étain (étamage).

Il est particulièrement avantageux que le support soit un ruban souple car cela permet de le monter sans problème sur des faces non planes.

Auxdits endroits déterminés, la plage conductrice peut avantageusement présenter une région étroite sensiblement égale à la dimension transversale des plages conductrices des éléments optiques.

Selon un mode de réalisation préféré, la largeur de la fente est inférieure à ladite dimension et est telle que l'élément repousse localement le support non rigide et est ainsi retenu de manière élastique, et sa longueur peut être telle qu'elle dépasse de part et d'autre de l'élément optique.

Après l'étape c, on peut réaliser dans le cas où au moins certains des éléments optiques sont électro-luminescents, une étape de revêtement par une couche réfléchissante de la première face du ruban opposée à l'émission de rayonnement lumineux et/ou de revêtement d'une deuxième face de ruban par laquelle s'effectue l'émission de rayonnement, par un film transparent et/ou d'adhésif. Lors d'une étape ultérieure, le support peut être sectionné de manière à obtenir des circuits optiques individualisées.

L'invention concerne également un circuit optique comportant des éléments optiques soudés en des endroits déterminés sur un support isolant non rigide revêtu d'au moins une piste conductrice, caractérisé en ce qu'elle comporte auxdits endroits déterminés des fentes dans lesquelles sont disposés des éléments optiques présentant deux plages conductrices, et en ce qu'un matériau de soudure est disposé de manière à souder chaque plage conductrice à une partie de piste conductrice correspondante.

La piste conductrice peut être avantageusement en cuivre au moins partiellement étamé et les plages conductrices en cuivre. Le ruban peut être souple et/ou transparent.

Auxdits endroits déterminés, ladite piste conductrice peut avantageusement présenter une région étroite sensiblement égale à la dimension transversale des plages conductrices des éléments électro-luminescents.

Selon un mode de réalisation préféré, les fentes ont une largeur telle qu'une force élastique de maintien est exercée sur les éléments optiques, et leur longueur peut être telle qu'elles dépassent de part et d'autre des éléments optiques.

La première face du ruban peut être revêtue d'une peinture réfléchissante et/ou d'une couche adhésive.

La deuxième face du ruban peut être revêtue

2

d'un film transparent.

Des éléments électro-luminescents et photo-récepteurs peuvent être disposés côte-à-côte ou couplés optiquement sur des faces opposées du support.

Les éléments optiques peuvent être disposés sur un bord du support, et avantageusement enrobés dans un profil cylindrique transparent.

L'invention sera mieux comprise à la lecture de la description qui va suivre, donnée à titre d'exemple non limitatif, en liaison avec les dessins qui représentent :

- la figure 1, un dispositif de l'art antérieur sur substrat céramique
- la figure 2, un mode de réalisation de l'invention dans lequel des éléments électro-luminescents sont montés en matrice
- les figures 3a et 3b des détails de la figure 2 respectivement en vue de dessus et en coupe longitudinale
- la figure 4, un détail représenté en perspective d'une variante de la figure 2
- la figure 5, un détail représenté en coupe longitudinale d'une autre variante de la figure 2
- la figure 6a à 6c, les étapes principales du procédé selon l'invention,
- la figure 7 un dispositif pour la mise en oeuvre du procédé selon l'invention,
- les figures 8 et 9, deux variantes de l'invention pour des éléments raccordés respectivement en série et en parallèle.

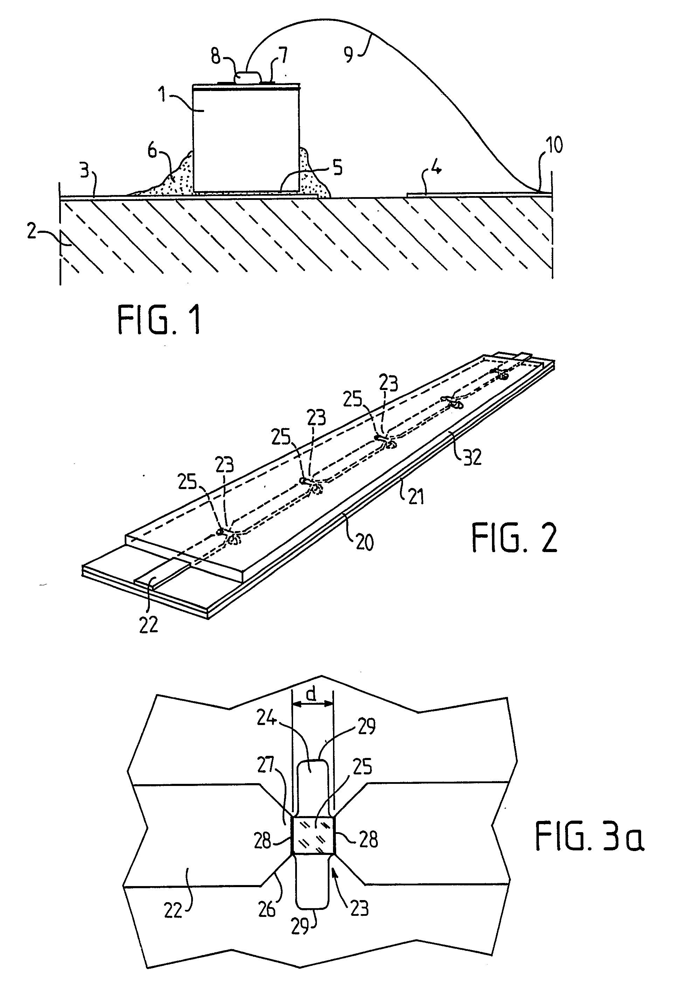

Selon la figure 1, un dispositif de l'art antérieur comporte un substrat céramique pour montage en surface et pourvu sur sa face supérieure de deux plages conductrices 3 et 4. Un élément électro-luminescent 1 en l'occurence un cristal est collé par sa face inférieure sur la plage conductrice 3 grâce à une colle conductrice 5. Une soudure 6 répartie sur le pourtour de la partie basse de l'élément 1 assure que la tenue mécanique et électrique soit suffisante. Un fil conducteur 9 est soudé en 8 et 10 de manière à connecter une électrode 7 de l'élément 1 à la plage conductrice 4.

Pour réaliser une matrice de tels éléments, il faut effectuer leur mise en place par montage en surface sur un substrat ce qui aboutit à des coûts élevés ainsi qu'à des épaisseurs non optimales.

Selon la figure 2, un ruban isolant 20 non rigide, à savoir flexible ou de préférence souple, comporte sur sa face supérieure une bande conductrice 22 présentant en des endroits déterminés 23 des fentes 24 dans lesquelles sont logés des éléments 25, par exemple des éléments électro-luminescents 25. Cette structure présente une épaisseur faible.

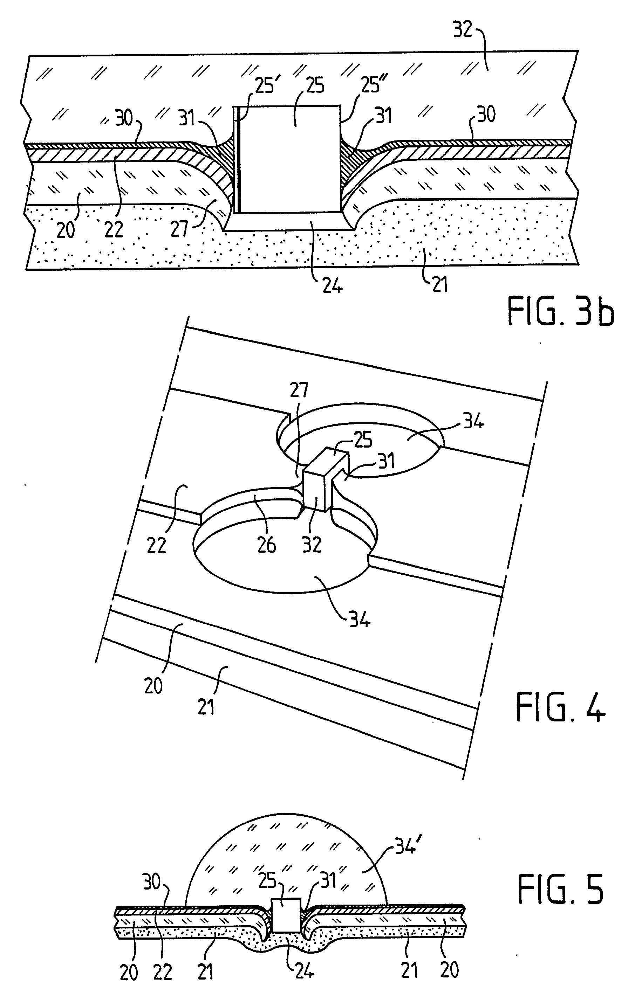

Selon les figures 3a et 3b, la bande 22, par exemple en cuivre, est revêtue d'une couche de soudure 30, par exemple un étamage, qui assure en 31 la continuité mécanique et électrique avec les électrode 25′ et 25″ de l'élément électro-luminescent 25, par exemple un cristal constituant une diode électro-luminescente. Ainsi qu'il sera mentionné dans la suite de la description, les éléments 25 ont avantageusement une dimension prise entre leurs électrodes légèrement supérieure à la largeur des fentes 24, ce qui fait que leur mise en place dans les fentes 24 par la face du ruban 20 portant la bande 22, s'effectue en repoussant localement le ruban 20 revêtu, qui les maintient ensuite en place par blocage élastique jusqu'à ce que la soudure des électrodes 25′ et 25″ et de la bande 22 soit effectuée. En outre, le fait que le ruban est repoussé crée une gouttière favorable au piégeage de la soudure 31 par les forces capillaires, ce qui augmente la surface de contact électrique. Cette structure peut en outre être fabriquée par un procédé continu, donc à faible coût. D'autres supports qu'un ruban 20 peuvent être mis en oeuvre, par exemple un support flexible constitué par une carte de crédit, une carte à mémoire ou analogue.

Le ruban 20 est de préférence transparent et revêtu à sa face inférieure d'une couche réfléchissante 21.

L'invention ne concerne pas seulement le cas des matrices. En effet, d'autres éléments optiques peuvent être associés, en combinaison ou séparément, pour former un circuit optique, par exemple des éléments photo-émetteurs et photo-récepteurs, les pistes conductrices pouvant être mises à profit pour leurs interconnexions et leurs alimentations, comme dans le cas d'un circuit imprimé. Les éléments optiques 45 peuvent être également des éléments à fonction purement optique mais qui ont été pourvus de deux plages conductrices en vue de leur montage dans une fente 24, par exemple des prismes. Dans ce cas, la bande 22 n'assure qu'une fonction mécanique pour les éléments purement optiques. L'invention permet aussi d'associer des éléments optiques de toutes sortes de manière à réaliser des circuits optiques selon des schémas désirés.

On remarquera en se reportant plus particulièrement à la figure 3a diverses dispositions facilitant la mise en place mécanique des éléments 25. D'une part, la fente 24 peut être plus longue que la dimension des éléments mise perpendiculairement à la dimension d entre les électrodes. Ceci a pour effet que l'écartement des bords de la fente n'est pas affecté par la proximité des extrémités 29 des fentes 24. D'autre part, la bande 22 peut présenter des rétrécissements 26 se terminant par des méplats 27 jouxtant les endroits déterminés 23 et dont la largeur est voisine de celle des électrodes 25′ et 25″. On obtient ainsi une plus grande élasticité.

En ce qui concerne maintenant les considérations de résistance thermique, on observe que la ou les bandes 22 forment au voisinage des électrodes 25′ et 25″ des ailettes de refroidissement. Il en résulte que le refroidissement des éléments 25 est bien mieux assuré que dans le cas de l'art antérieur (fig. 1).

Les éléments 25 peuvent être des éléments optiques à fonction électrique tels que, outre les éléments électro-luminescents, les éléments photo-récepteurs par exemple, ou bien des pièces optiques sans fonction électrique telles que des prismes par exemple, et comportant deux plages conductrices sur des faces opposées en vu de leur fixation par soudure.

La figure 4 représente une variante dans laquelle les fentes 24 présentent, de part et d'autre de l'élément électro-luminescent 25, un contour circulaire 34. De la sorte, la lumière émise par les faces latérales 32 de l'élément 25 peut être recueillie sans qu'elle traverse le ruban 20.

Selon la figure 5, l'élément 25 est pourvu d'un dôme hémisphérique transparent 34, par exemple en résine, permettant d'améliorer le couplage optique. Ce dôme 34 peut être réalisé par dépôt d'une goutte de résine qui permet d'accroître l'intensité émise dans l'axe. Pour la plupart des applications, on considère surtout le flux lumineux exploitable qui est particulièrement bien conservé par cette structure qui présente un support transparent, un film réfléchissant et une absence d'occultation du cristal.

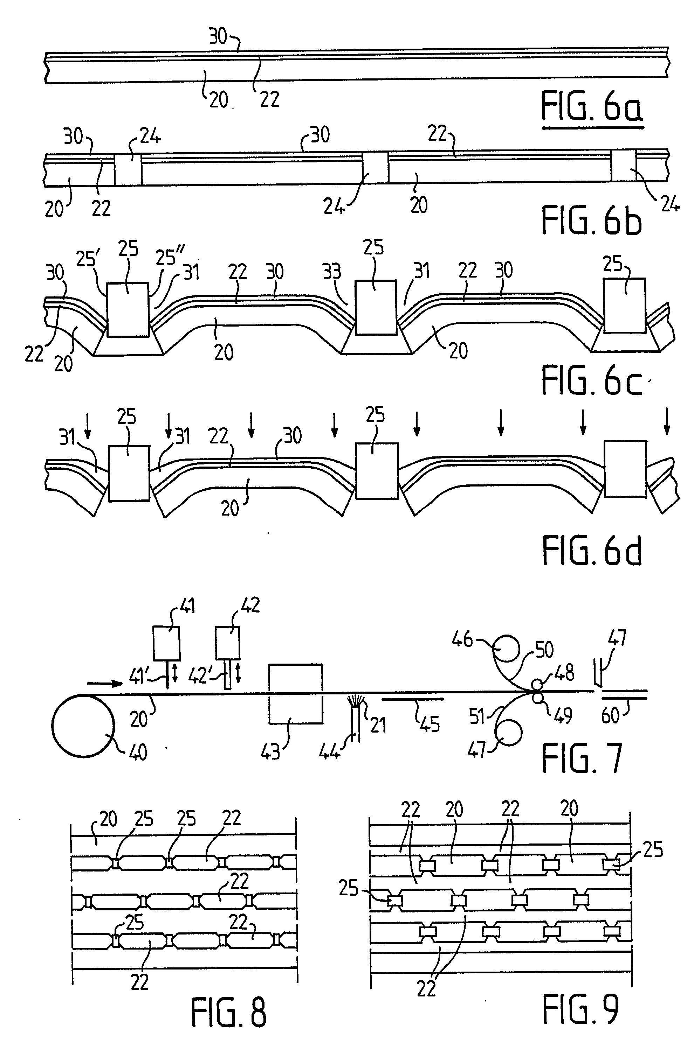

Les figures 6a à 6c représentent les étapes principales du procédé de fabrication. Selon la figure 6a, on part d'un ruban 20 présentant sur sa face supérieure un motif conducteur 22 en cuivre, recouvert d'une couche de soudure 30, en l'occurence un étamage. Selon la figure 6b, les fentes 24 sont découpées aux endroits déterminés.

Selon la figure 6c, les éléments 25 sont insérés dans les fentes 24 et y restent maintenus, avec leurs électrodes 25′ et 25″ en contact avec la soudure 30, par les forces élastiques produites par les bords repoussés localement du ruban 20. Selon la figure 6d, après fusion de la soudure 30, les électrodes 25′ et 25″ sont soudées dans les gouttières 31 au motif 22.

La figure 7 représente un dispositif pour la mise en oeuvre du procédé. Un ruban souple 20 revêtu est déroulé à partir d'un touret 40, et est soumis en continu aux opérations suivantes : découpe des fentes 24 par un outil 41′ commandé par un dispositif asservi en position 41, mise en place des éléments 25 par un palpeur 42′ à dépression commandé par un dispositif asservi 42, fusion de la soudure 30 dans un tunnel chauffant 43, pulvérisation de peinture réfléchissante 21 à la face inférieure du ruban opposée à l'insertion des éléments 25, grâce à un dispositif à buse 44, séchage de la peinture par une plaque chauffante 45, mise en place sur la face inférieure d'un ruban adhésif double face 51 débité à partir d'un touret 47 (ou bien enduction avec un adhésif), mise en place sur la face supérieure d'un film protecteur 50 débité à partir d'un touret 46, découpe par un poste de découpe 47, par exemple par découpe laser, et enlèvement des matrices 48 découpées à l'aide d'un tapis roulant 60.

Les figures 8 et 9 représentent deux variantes de matrices. A la figure 8, plusieurs bandes 22 sont disposées en parallèle sur un ruban 20, et les éléments 25 sont disposés régulièrement le long de celles-ci, ceci correspondant à une alimentation électrique en série des éléments de chaque bande.

A la figure 9, les éléments 25 sont disposés entre des bandes parallèles 22, ce qui correspond à une alimentation électrique en parallèle.

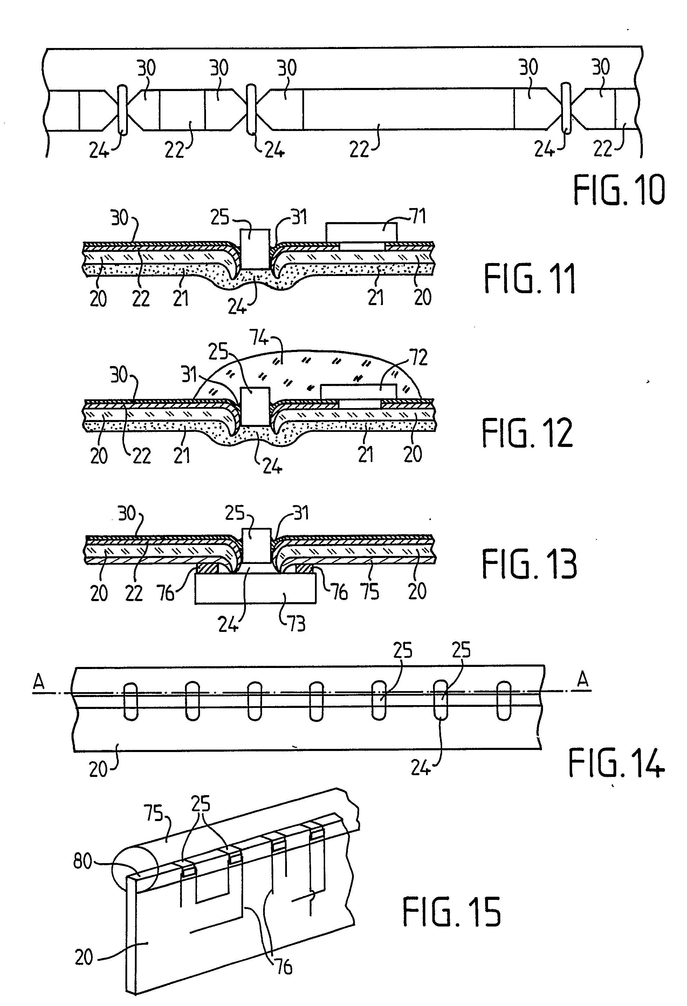

Selon la figure 10, la couche de soudure 30 ne recouvre la bande 22 qu'au voisinage des fentes 24.

Selon la figure 11, un élément électro-luminescent 25 est placé à proximité d'un élément photo-récepteur 71 monté en surface de manière à former, par exemple, un détecteur de proximité. L'élément photo-récepteur 71 pourrait, en variante, être monté dans une fente telle que 24.

Selon la figure 12, un élément électro-luminescent 25 et un élément photo-récepteur 72 sont disposés au voisinage l'un de l'autre et enrobés d'une résine 74 de manière à former un photo-coupleur.

Selon la figure 13, un élément électro-luminescent 25 monté par la face supérieure de la bande 20 dans une fente 24 coopère avec un circuit photo-récepteur 73 monté en surface par des plages conductrices 76 sur une métallisation de la face opposée de la bande 20. Le circuit 73 est susceptible de recevoir une partie des rayons lumineux émis par l'élément 25 et peut donc traiter un tel signal. Une application intéressante est un point lumineux d'un écran plat.

Selon la figure 14, un ruban 20 présente une rangée d'éléments 25, par exemple des diodes électro-luminescentes montées comme indiqué précédemment dans des fentes 24. Le ruban 20 est sectionné longitudinalement par exemple par le poste de découpe 47 de la figure 7, par exemple par découpe laser, au voisinage d'un bord latéral des éléments 25. On obtient ainsi un circuit optique représenté à la figure 15. Les éléments 25 sont situés le long d'un bord 80 du ruban 20. Des connexions électriques 76 permettent de raccorder électriquement les éléments 25 selon le schéma désiré. Pour faciliter l'émission lumineuse, un profil cylindrique transparent 75, par exemple à section circulaire, est extrudé le long du bord 80. Cette structure peut être mise en oeuvre pour réaliser par exemple un bus optique.

**Revendications**

1. Procédé de montage d'éléments optiques sur un support caractérisé en ce qu'il comporte les étapes suivantes :

a) réaliser des fentes (24) de largeur sensiblement égale à une dimension d'un dit élément électro-luminescent (25) à des endroits déterminés (23), d'un support isolant non rigide (20) revêtu d'au moins une piste conductrice (22) recouverte au moins partiellement d'un matériau de soudure (30) de telle sorte que deux bords opposés desdites fentes (24) jouxtent chacun une partie dudit matériau (30)

b) introduire dans au moins certaines de ces fentes (24) un élément optique (25) présentant deux plages conductrices (25', 25") espacées selon ladite dimension de telle sorte que lesdits éléments optiques (25) se trouvent retenus dans les fentes correspondantes et que leurs plages conductrices (25', 25") soient en contact avec lesdites parties dudit matériau (30)

c) chauffer de manière à provoquer la fusion dudit matériau (30) de manière à réaliser une soudure entre chacune desdites plages conductrices (25', 25") et la piste conductrice (22) correspondante.

2. Procédé selon la revendication 1 caractérisé en ce que la piste conductrice (22) est en cuivre.

3. Procédé selon une des revendications 1 ou 2 caractérisé en ce que ledit matériau de soudure (30) est à base d'étain.

4. Procédé selon une des revendications précédentes caractérisé en ce que le support (20) est un ruban souple.

5. Procédé selon une des revendications précédentes caractérisé en ce qu'auxdits endroits déterminés (23), la plage conductrice (22) présente une région étroite (27) sensiblement égale à la dimension transversale des plages conductrices (25', 25") des éléments optiques (25).

6. Procédé selon une des revendications précédentes caractérisé en ce que la largeur de la fente (24) est inférieure à ladite dimension et est telle que l'élément optique (25) repousse localement le support (20) et est ainsi retenu de manière élastique.

7. Procédé selon la revendication 5, caractérisé en ce que la longueur de la fente (24) est telle qu'elle dépasse de part et d'autre de l'élément optique.

8. Procédé selon une des revendications précédentes caractérisé en ce que l'étape c du chauffage est réalisée par passage en continu dans un tunnel chauffant (43).

9. Procédé selon une des revendications précédentes caractérisé en ce qu'au moins un élément optique (25) est électro-luminescent et en ce qu'il comporte après l'étape c une étape de revêtement par une couche réfléchissante (21) d'une première face du ruban opposée à l'émission de rayonnement lumineux.

10. Procédé selon la revendication 9 caractérisé en ce qu'il comporte après l'étape c une étape de revêtement par un film transparent (50) d'une deuxième face du ruban (20) par laquelle s'effectue l'émission de rayonnement.

11. Procédé selon une des revendications précédentes caractérisé en ce qu'il comporte une étape de réalisation d'une couche adhésive (51) sur la première face.

12. Procédé selon une des revendications précédentes caractérisé en ce qu'il comporte une étape ultérieure de sectionnement du support (20) de manière à obtenir des circuits optiques individualisées (48).

13. Procédé selon la revendication 12 caractérisé en ce que l'étape de sectionnement du support (20) comporte une opération de sectionnement longitudinal au voisinage d'un bord des éléments (25).

14. Circuit optique comportant des éléments optiques soudés en des endroits déterminés sur un support isolant non rigide revêtu d'au moins une piste conductrice caractérisé en ce qu'il comporte auxdits endroits déterminés (23) des fentes (24) dans lesquelles sont disposés des éléments optiques (25) présentant deux plages conductrices (25', 25") et en ce qu'un matériau de soudure (30) est disposé de manière à souder chaque plage conductrice (25', 25") à une partie de piste conductrice correspondante (22).

15. Circuit selon la revendication 14 caractérisé en ce qu'une dite piste conductrice (22) est en cuivre et est revêtue au moins partiellement d'un étamage et en ce que les plages conductrices sont en cuivre.

16. Circuit selon la revendication 15 caractérisé en ce que le support (20) est un ruban souple.

17. Circuit selon une des revendications 14 à 16 caractérisé en ce que le support (20) est transparent.

18. Circuit selon la revendication 17 caractérisé en ce qu'au moins un élément optique est électroluminescent et en ce que la première face du support (20) opposée à l'émission de rayonnement lumineux est revêtue d'une couche réfléchissante (21).

19. Circuit selon la revendication 18 caractérisé en ce que la deuxième face du support par laquelle s'effectue l'émission du rayonnement est revêtue d'un film transparent (50).

20. Circuit selon une des revendications 14 à 19 caractérisé en ce qu'auxdits endroits déterminés une dite plage conductrice (25′, 25″) présente une région étroite (27) sensiblement égale à la dimension transversale des plages conductrices des éléments optiques (25).

21. Circuit selon une des revendications 14 à 20 caractérisé en ce que la largeur des fentes (24) est telle qu'une force élastique de maintien est exercée sur les éléments optiques (25).

22. Circuit selon la revendication 20 caractérisé en ce que la longueur des fentes (24) est telle qu'elle dépasse de part et d'autre de l'élément optique (25).

23. Circuit selon une des revendications 14 à 22 caractérisé en ce que la première face du support (20) est revêtue d'une couche adhésive (51).

24. Circuit selon une des revendications 14 à 23 caractérisé en ce qu'au moint un élément optique (25) est une pièce optique.

25. Circuit selon une des revendication 14 à 24 caractérisé en ce qu'il comporte au moins un premier élément électro-luminescent et un premier élément photo-récepteur disposés au voisinage l'un de l'autre.

26. Circuit selon une des revendication 14 à 25 caractérisé en ce qu'il comporte au moins un deuxième élément électro-luminescent, et en ce qu'un deuxième élément photo-récepteur est disposé sur une face du support opposée à l'émission de rayonnement lumineux de manière à recevoir au moins une partie de la lumière émise par ledit élément (25).

27. Circuit selon une des revendications 14 à 26 caractérisé en ce que les éléments (25) sont disposés sur au moins un bord du support (20) et sont enrobés dans un profil cylindrique transparent (75).

FIG. 1

FIG. 2

FIG. 3a

1-IV-PHF 88-528

FIG. 3b

FIG. 4

FIG. 5

FIG. 6a

FIG. 6b

FIG. 6c

FIG. 6d

FIG. 7

FIG. 8

FIG. 9

FIG.10

FIG.11

FIG.12

FIG.13

FIG.14

FIG.15

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 111 222  (SIEMENS AG)<br>* figure 3, page 4, lignes 21-32 *<br><br>--- | 1-6,14-16,20, 21 | H 05 K   3/30 |
| A | DE-A-2 907 270  (LICENTIA)<br>* figure 1; page 6, lignes 8-32 *<br>--- | 1,14,21 ,24 | |
| A | EP-A-0 133 396  (TELEMECANIQUE ELECTRIQUE)<br>* figures 3,4; page 3, ligne 34 - page 4, ligne 29 *<br>--- | 1,14,24 | |
| A | FR-A-2 271 740  (AMERICAN MICROSYSTEMS)<br>* figures 2,3; page 5, ligne 13 - page 7, ligne 3 *<br>----- | 1-3,5,7 ,14,15 | |

**DOMAINES TECHNIQUES RECHERCHES (Int. Cl.4)**

H 05 K   3/00

Le présent rapport a été établi pour toutes les revendications

| Lieu de la recherche | Date d'achèvement de la recherche | Examinateur |
|---|---|---|
| BERLIN | 19-07-1989 | HAHN G |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
...........................................................................
& : membre de la même famille, document correspondant